Europäisches Patentamt

European Patent Office

Office européen des brevets

(11) Publication number: **0 148 082**
**B1**

(12) **EUROPEAN PATENT SPECIFICATION**

(45) Date of publication of patent specification: **11.10.89**

(21) Application number: **84402695.5**

(22) Date of filing: **21.12.84**

(51) Int. Cl.⁴: **H 03 K 5/02**

(54) Driver for differential signal transmission.

(30) Priority: **23.12.83 JP 243474/83**

(43) Date of publication of application:
**10.07.85 Bulletin 85/28**

(45) Publication of the grant of the patent:
**11.10.89 Bulletin 89/41**

(84) Designated Contracting States:
**DE FR GB**

(56) References cited:
**DE-A-2 027 515**
**US-A-3 780 316**

**PATENTS ABSTRACTS OF JAPAN, vol. 7, no.
276 (E-215)1421r, 9th December 1983; & JP-A-
58 154 923**

**IBM TECHNICAL DISCLOSURE BULLETIN, vol.
21, no. 9, February 1979, pages 3607,3608, New
York, US; E.L. CARTER: "Cascode clock driver"**

(73) Proprietor: **FUJITSU LIMITED**
**1015, Kamikodanaka Nakahara-ku
Kawasaki-shi Kanagawa 211 (JP)**

(72) Inventor: **Emori, Shinji**
**1345-51, Trajima
Urawa-shi Saitama 336 (JP)**

(74) Representative: **Descourtieux, Philippe et al
CABINET BEAU de LOMENIE 55 rue
d'Amsterdam
F-75008 Paris (FR)**

EP 0 148 082 B1

## Description

### Background of the invention

The present invention relates to a driver for transmitting a digital differential signal, and more particularly, to a driver which can eliminate common mode signal reflection occurring in a transmission line and producing errors in signal transmission.

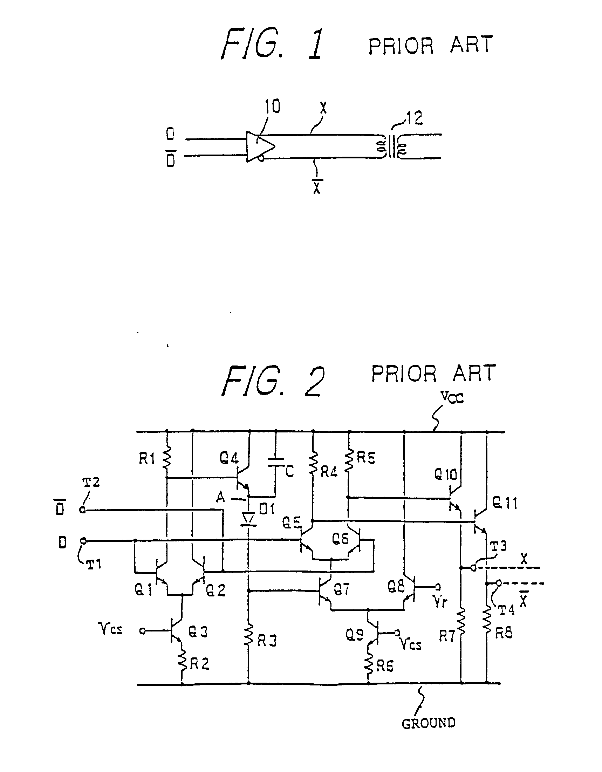

A digital differential signal is used for signal transmission in a system such as a local area network (LAN) system, and is used for protecting a signal being transmitted through a transmission line, such as twisted pair-wire, from electric noise which comes from outside of the transmission line. As shown in Fig. 1, a transmission system for a digital differential signal consists of a driver 10, a transmission line $X-\overline{X}$, and a transformer 12. An input digital differential signal $D-\overline{D}$ is driven by the driver 10 producing a digital differential signal output on the transmission line $X-\overline{X}$. The transmission line $X-\overline{X}$ transmits the driven digital differential signal toward a receiving side where the transmission line $X-\overline{X}$ is terminated by the transformer 12. If the standard No. 802.3 of the "Institute of Electrical and Electronics Engineers" (IEEE) is given to the digital differential signal as a typical example for the LAN system, the driver 10 in Fig. 1 is included in a "Date Terminal Equipment" (DTE), the transformer 12 is included in a "Medium Attachment Unit" (MAU), and the transmission line $X-\overline{X}$ corresponds to a "data out line" of a "Attachment Unit Interface" (AUI).

The digital differential signal output includes two kinds of signal voltages differential voltage and common voltage. When $V_X$ is the instantaneous voltage on the line $X$ and $V_{\overline{X}}$ is the instantaneous voltage on the line $\overline{X}$, the differential voltage $V_{diff}$ is defined as:

$$V_{diff} = V_X - V_{\overline{X}} \qquad (1),$$

and the common voltage $V_{comm}$ is defined as:

$$V_{comm} = \frac{V_X + V_{\overline{X}}}{2} \qquad (2).$$

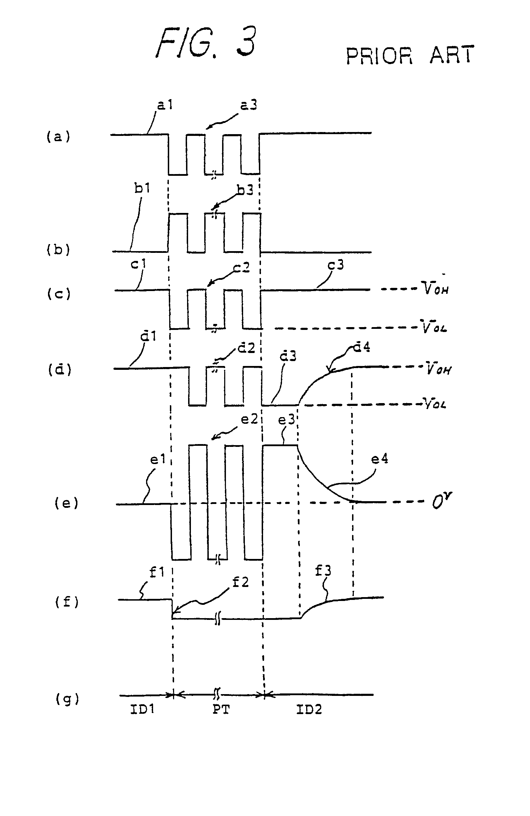

In a LAN system, generally, transmitting data are encapsulated, coded, and transmitted in a state of a packet, so that the transmission line is in a state of either transmitting the packet or no signal; time intervals for the former and the later states are respectively called "packet time" and "idle time" and the data signal is transmitted only in the packet time. In the packet time, the lines $X$ and $\overline{X}$ voltages differentially change to a high (H) or a low (L) level respectively following a transmitting coded data signal. However, the levels of respective lines $X$ and $\overline{X}$ do not change in the idle time because there is no signal. Furthermore, as the transmission line is terminated by the transformer 12, it can not be allowed to flow direct current through the transformer 12 for avoiding saturation of its magnetic core. The driver 10 of the prior art will be discussed first showing its circuit diagram in Fig. 2 and related wave forms in Fig. 3.

The driver of the prior art substantially consists of emitter coupled logic (ECL) circuits to enable high speed operation. Transistors Q1, Q2; Q5, Q6; and Q7, Q8 in Fig. 2 are respectively matched to each other and compose the ECL circuits with their common emitter loads Q3, R2 and Q9, R6 which function as constant current sources. Each ECL circuit operates as a switching circuit. In the ECL circuit Q1−Q2 for example, Q2 is brought to be cut off when Q1 is on and vice versa because the common emitter load (Q3 and R2) keeps its current constant. A base voltage $V_{cs}$ is applied to Q3 and Q9 for proper bias adjustment.

The switching circuit Q5−Q6 works as a driving circuit, transistors Q10 and Q11 are emitter followers which produce the digital differential signal output receiving a differential output from the driving circuit at their bases, and output terminals T3 and T4 are connected to transmission lines $X$ and $\overline{X}$ respectively. These circuits compose a main circuit for a driver. In addition to the main circuit, a packet time detecting circuit and a drive controller are provided. The switching circuit Q1−Q2, a transistor Q4, a capacitor C, a diode D1, and a resistor R3 compose the packet time detecting circuit, by which the packet time can be detected in the successive periods and the differential voltage on the transmission line $X-\overline{X}$ can be gradually shifted to zero when the period changes to idle time from packet time. The switching circuit Q7−Q8 composes the drive controller which controls the driving circuit Q5−Q6 so as to drive an initial differential coded data signal in the packet time and to produce an initial zero differential voltage in the idle time having the gradual shift.

A detail of a prior art driver circuit will be explained in the case of "Manchester Coded Data", i.e. packet data coded by the standard No. 802.3 of the IEEE, using the wave forms shown in Fig. 3. That is, in the packet according to said standard, the level of data at the idle time is "1" (D=H) and the coded data at the packet time appear as a data train having at least an edge in one bit-time. In Fig. 3, lines (a) and (b) respectively show the voltage of the input signal D at T1 and $\overline{D}$ at T2, these voltages being applied to switching circuits Q1−Q2 and Q5−Q6; lines (c) and (d) respectively show the voltages of the output signals at T3 and T4; line (e) shows an output differential signal between T3 and T4; line (f) shows a common voltage between the transmission line $X-\overline{X}$ and ground; and line (g) shows periods in which the symbol PT indicates the packet time, and ID1 and ID2 respectively indicate the idle time just before and after PT.

During a period ID1, an idle signal (I)=H, $\overline{D}$=L) is applied to input terminals T1 and T2, so the driver is in a steady state as follows.

(1-1) As shown by parts a1 and b1 in Figures 3(a) and (b), the input voltage applied to the base of transistor Q1 is higher than the input voltage applied to the base of transistor Q2, so Q1 is ON and Q2 is OFF.

(1-2) As transistor Q1 is ON, current of the constant current source consisting of Q3 and R2 flows through R1, producing at the collector of Q1 a voltage drop according to the constant current and R1. As Q4, D1, and R3 form an emitter follower circuit, the voltage at the emitter of Q4 becomes $V_{OL}$ which is lower than the voltage at the collector of Q1 by as much as $V_{BE}$ (base-emitter forward voltage), so, a voltage equal to the difference between $V_{cc}$ (power source voltage) and $V_{OL}$ is charged on the capacitor C.

(1-3) By adjusting the base voltage (reference voltage $V_r$) of Q8 properly, the base voltage of Q7 can be set to be lower than the reference voltage $V_r$ and Q7 can thus be made OFF.

Therefore, the drive controller controls the driving circuit Q5—Q6 to be cut off. This causes the base voltages of the emitter followers Q10 and Q11 to increase up to $V_{cc}$.

(1-4) So, the highest voltage level $V_{OH}$ appears on both output terminals T3 and T4; parts c1 and d1 in Figure 3(c) and (d) show this state. Therefore, the differential voltage between X and $\overline{X}$ during ID1 is equal to zero as shown in part e1 of Figure 3(e). As a result, no direct current flows in the transformer 12 of Fig. 1, so that the core saturation in the transformer 12 is avoided.

When the period changes to PT from ID1, an input digital differential signal is applied to the terminals T1 and T2 having the pair of waveforms shown by parts a3 and b3 in Figure 3(a) and (b). This pair of waveforms is standardized by a standard No. 802.3 of the "Institute of Electrical and Electronics Engineers" (IEEE). When the driver receives such a digital differential signal, the state of the driver changes as follows.

(2-1) The transistors Q1 and Q2 begin to be switched OFF and ON by the input digital differential signal. Especially, Q1 is switched off when an initial negative pulse is applied to its base. Transistors Q4 outputs then a high level, which causes the capacitor C to be discharged quickly, and the base voltage of Q7 in the drive controller rapidly increases. Though the next positive pulse cuts Q4 off, the base voltage of Q7 is kept high, because the RC circuit comprising C, D1, and R3 has a large time constant in comparison with the bit-time; that is, the next coded datum of L level is fed to the base of Q1 early before the voltage at point A of Fig. 2 decreases. This state is kept on as long as the digital differential signal exists, in other words, during the period PT. This means that the above circuit serves as packet time detector.

(2-2) As Q7 is switched on, Q8 is switched off. So, the drive controller Q7—Q8 controls the driving circuit Q5—Q6 so as to produce an original digital differential signal from collectors of Q5 and Q6 corresponding to the input differential signal applied to their bases.

(2-3) So the emitter followers Q10 and Q11 produce the digital differential signal output shown by c2 and d2 in Figure 3 (c) and (d) on the

transmission lines X—$\overline{X}$. Reference symbol e2 in Figure 3(e) shows the differential voltage between the lines X and $\overline{X}$.

When the period changes to ID2 from PT, the state of the driver changes as follows.

(3-1) The base voltage of Q1 is returned so as to switch Q1 on. Transistor Q4 is then driven to be cut off and capacitor C begins to be charged through D1, R3, and the power source. Therefore, the base voltage of Q7 gradually decreases, and the voltage at point A decreases and keeps to the low level.

(3-2) The driving circuit Q5—Q6 intends to return to the state it had in the ID1 period as stated before. However before returning to this state, the following transient phenomena occur in the circuit of the driver. As the base voltage of Q7 gradually decreases, its internal resistance gradually increases. This affects the driving circuit Q5—Q6. More precisely, Q6 is not affected, because it has been switched off, but Q5 is affected because it has been switched on. At the early time of the change of the period of ID2 from PT, the voltage at point A does not decrease at once, and a state of Q7 being OFF is kept because the base voltage of Q7 is sufficiently higher than that of Q8. After a while, when the voltage at point A has decreased more so that the base voltages of Q7 and Q8 become equal to each other, the current flow gradually changes to Q8 from Q7. This can be seen in Figure 3(c) and (d); a flat part c3 in Figure 3(c) corresponds to Q6 being OFF; a flat part d3 in Figure 3(d) corresponds to Q5 being ON for a while; and a gradually changing part d4 in Figure 3(d) corresponds to the collector current of Q5 which gradually decreases. The phenomenon corresponding to the part d4 affects the differential voltage between the transmission lines X and $\overline{X}$, the influence appearing also gradually as shown by part e4 in Figure 3(e).

The differential voltage between the transmission lines consists only of signals to be transmitted as shown by Figure 3(e). Just considering this figure, it seems as if there were no problem like signal reflection occurrence on the transmission line. However, a variation is concealed in the common voltage of the transmitting signal as shown by Figure 3(f), in the form of a steep transient f2. This transient results from the difference of mean voltage between the periods ID1 and PT. This difference can easily be obtained by adding the waveforms of Figure 3(c) and (d), the result being shown by Figure 3(f). The steep transient is transmitted along the transmission line X—$\overline{X}$, and makes a round trip between the driver 10 and the transformer 12 of Fig. 1 due to the reflection caused by their mismatched common mode impedance. It is actually very hard to match common mode impedance perfectly, so occurring of reflection cannot be avoided (another transient part f3 appearing in Figure 3(f) is gentle, so there is no like problem due to the reflection). When such reflection occurs, the reflected waves superimpose onto the transmitting digital differential signal, causing unexpected errors in the transmitting signals. This steep variation of the common voltage is a problem with the above described prior art driver.

Summary of the invention

An object of the present invention is to eliminate reflected signals which occur in a transmission line and produce errors in digital differential signal transmitted through the line.

Another object of the present invention is to provide a constant common voltage of the transmitting signal on the transmission line through the whole periods of idle time and packet time.

Foregoing objects are attained by providing driver, having an input transmission line and an output transmission line, for transmitting a digital differential signal, as a pair of signals at first and second levels along a transmission line during a packet time, and for not transmitting the digital differential signal during an idle time, said driver comprising:

first and second input terminals coupled to the input transmission line for receiving an input signal;

first and second output terminals (T3, T4) coupled to the output transmission line;

a driving circuit including:

a first pair of transistors each transistor having an emitter, the emitters being connected together a base, the bases being connected to the respective first and second input terminals, and a collector and a pair of collector loads, operatively connected to the respective collectors of said first pair of transistors, said driving circuit providing said digital differential signal at the collectors of said first pair of transistors;

a drive controller including:

a second pair of transistors each transistor having an emitter, the emitters being connected together, and each transistor having a collector, and one of the collectors of said second pair of transistors being operatively connected to the emitters of said first pair of transistors;

a constant current source operatively connected to the emitters of said second pair of transistors; and

a packet time detecting circuit, operatively coupled to receive said input signal, supplying a first current to the drive controller by turning on one of the transistors of said second pair of transistors when the level of the input signal received at said first and second input terminals is variable and supplying a second current by turning on the other of the transistors of said second pair of transistors when the input signal is not variable.

According to the invention, the driver further comprises a pair of current separating means, operatively connected to the other one of the collectors of said second pair of transistors and being directly connected to said pair of collector loads, respectively, for causing one-half of the current provided by the constant current source to flow in each of the collector loads of said pair of collector loads to produce a mean voltage value level midway between said first and second levels at the collectors of said first pair of transistors when the digital differential signal is not being transmitted, and said drive controller supplying the current produced by said constant current source to said driving circuit during the packet time and to said current separating means during the idle time, respectively.

Thus, the common voltage produced during the idle time periods is equal to the mean voltage between the high and low levels of the digital differential signal during the packet time periods.

The current separating means may be in the form of matched diodes or matched transistors.

The invention will be more readily understood from the reading of the following description made with reference to the accompanying drawings.

Brief description of the drawings

Fig. 1 is an illustrating diagram of a system for digital differential signal transmission;

Fig. 2 is a circuit diagram of a prior art driver;

Fig. 3 shows waveforms for illustrating the working of the prior art driver of Fig. 2;

Fig. 3(a) is a waveform of one part of an input digital differential signal;

Fig. 3(b) is a waveform of another part of an input digital differential signal;

Fig. 3(c) is a waveform of one part of an output digital differential signal;

Fig. 3(d) is a waveform of another part of an output digital differential signal;

Fig. 3(e) is a waveform of the differential voltage between paired lines of the transmission line;

Fig. 3(f) is a waveform of the common voltage of the digital differential signal; and

Fig. 3(g) is a time scale indicated by time periods;

Fig. 4 is a circuit diagram of a driver according to an embodiment of the present invention;

Fig. 5 shows waveforms for illustrating the working of a driver according to the present invention;

Fig. 5(a) is a waveform of one part of an input digital differential signal, which is the same as that of Fig. 3(a);

Fig. 5(b) is a waveform of another part of an input digital differential signal, which is the same as that of Fig. 3(b);

Fig. 5(c) is a waveform of one part of an output digital differential signal;

Fig. 5(d) is a waveform of another part of an output digital differential signal;

Fig. 5(e) is a waveform of differential voltage between paired lines of a transmission line;

Fig. 5(f) is a waveform of common voltage of the digital differential signal output;

Fig. 5(g) is a time scale indicated by time periods, which is the same as that of Fig. 3(g); and

Fig. 6 is a circuit diagram of a driver according to another embodiment of the present invention.

Detailed description of the invention

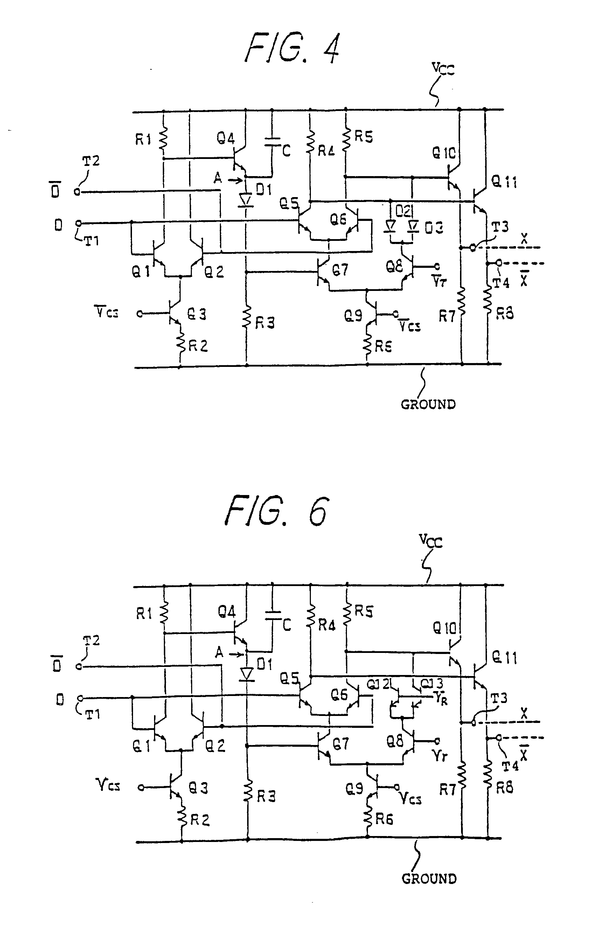

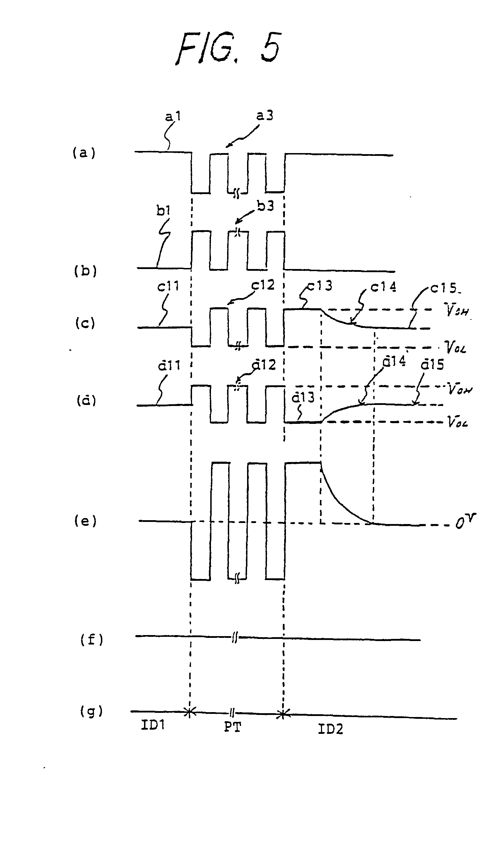

A circuit diagram of a driver according to an embodiment of the present invention is shown in Fig. 4, and waveforms for illustrating the working of the circuit are shown in Fig. 5.

In Figs. 2 and 4, the same reference symbols designate the same elements or parts, and also in Figs. 3 and 5, the same symbols designate the same functions.

In the circuit of Fig. 4, main function is similar to that of the prior art driver shown by Fig. 2. A digital differential signal input as shown by Figures 5(a) and (b) is received by the two pair of input terminals T1 and T2; the terminal T1 is for the input signal (a) and T2 is for (b). The input signals are respectively applied to the bases of the paired matched transistors Q1, Q2 and Q5, Q6. The paired matched transistors are respectively composed of an ECL circuit and function as a switching circuit. Transistors Q7 and Q8 also form the same kind of switching circuit. The switching circuit Q8–Q6 functions as a driving circuit, and emitter followers Q10 and Q11 produce the driver output digital differential signal to the transmission line $X-\overline{X}$ at T3 and T4. In addition, to the above main circuits, a packet time detecting circuit is provided. This circuit consists of the same elements as that of Fig. 2, and its function is also the same. However, function and structure of the drive controller circuit are different from that of the corresponding circuit in Fig. 2. A diode D2 is placed between the collectors of Q8 in the drive controller and Q5 in the driving circuit, and a diode D3 is placed between the collectors of Q8 and Q6.

The diodes D2 and D3 are for providing a constant common voltage at the driver output through the whole periods ID1, PT, and ID2. During period ID1, the transistor Q7 in the drive controller is cut off as mentioned with reference to Fig. 2, so that the driving circuit Q5–Q6 does not flow collector current. However, Q8 in the drive controller flows current through R4–D2 and R5–D3, respectively. The resistors R4 and R5 are paired matched collector resistors in the driving circuit Q5–Q6. Therefore, one half of the constant current of Q9 flows through the collector resistor R4 and the other half through the collector resistor R5. The voltage drop across each resistor R4, R5 is just half of the voltage drop when the full constant current of Q9 flows across R4 or R5 according as transistor Q5 or Q6 is ON or OFF. As a result, the common voltage at the driver output on the transmission line $X-\overline{X}$ becomes just equal to the middle value between $V_{OH}$ and $V_{OL}$. Reference symbols c11 and d11 in Figure 5(c) and (d) show this middle value voltage in period ID1.

When changing from period ID1 to PT, the transistor Q7 is switched on as mentioned with respect to Fig. 2. The driver Q5–Q6 is then controlled to allow the emitter follower Q10–Q11 to produce the driver output $V_{OH}$ and $V_{OL}$ as shown by c12 and d12 in Figures 5(c) and d).

When changing from period ID1 to PT, the transistor Q7 is switched on as mentioned with respect to Figure 2. Then driver Q5–Q6 is controlled to allow the emitter follower Q10–Q11 to produce the driver output $V_{OH}$ and $V_{OL}$ as shown by c12 and d12 in Figures 5(c) and (d).

When changing from period PT to ID2, the base voltage of Q7 in the drive controller is gradually reduced and at last Q7 is driven to be cut off because of the flowing of charging current for C through D1, R3, and the power source as mentioned with respect to Figure 2. As the common emitter load Q9, R6 in the drive controller functions as a constant current source, the transistor Q8 intends to substitute for transistor Q7 to keep the constant current flow. As long as transistor Q7 flows enough collector current, only Q5 flows its collector current and Q6 is cut off in the driving circuit; Q8 is then kept in cut off state in the drive controller and the flat parts c13 and d13 in Figure 5(c) and (d) are obtained at the driver output. When the collector current of Q7 begins to decrease, this affects the driving circuit so that the collector current of Q5 decreases, and at the same time, this affects Q8 which begins to flow its collector current so that the collector voltage of Q5 increases more and the collector voltage of Q6 gradually decreases. This state is illustrated by the transient parts c14 and d14 in Figures 5(c) and (d). And when Q7 is driven to be completely cut off, the driving circuit Q5–Q6 is cut off, but Q8 is substituted for Q7 so that the full collector current of Q8 is separated in two halves, respectively through R4, D2 and R5, D3 respectively. This state remains until next period PT comes.

This is shown by the steady parts c15 and d15 in Figure 5(c) and (d).

Consequently, the differential voltage between the transmission lines X and $\overline{X}$ and the common voltage in the digital differential signal are as shown in Figure 5(e) and (f) respectively. It can be seen that there is no problem like common mode signal reflection, and only digital differential mode signal is transmitted even though the common impedance is mismatched at the end of the transmission line.

A pair of matched transistors Q12 and Q13 can be used as shown in Figure 6 instead of the matched diodes D2 and D3 of Figure 4. In this case, both bases are connected together and receive a proper base voltage $V_R$ to obtain the desired constant common voltage.

In the above, it has been indicated that the input signal of the driver is a differential signal. However, from the characteristics of the switching circuits Q1–Q2 and Q5–Q6, which compose the ECL circuits respectively, it is clear that the following inputs can also be applied to the driver: a $\overline{D}$ input fixed to a standard voltage so that its value is approximately equal to the middle value between H and L levels of the D input, or a D input fixed at a standard voltage so that its value is approximately middle value between the H and L levels of the $\overline{D}$ input.

## Claims

1. A driver, having an input transmission line (D, $\overline{D}$) and an output transmission line (X, $\overline{X}$), for transmitting a digital differential signal, as a pair of signals at first and second levels along a transmission line during a packet time, and for not transmitting the digital differential signal during an idle time, said driver comprising:

first and second input terminals (T1, T2) coupled to the input transmission line (D, $\overline{D}$) for receiving an input signal;

first and second output terminals (T3, T4) coupled to the output transmission line (X, $\overline{X}$);

a driving circuit including:

a first pair of transistors (Q5, Q6), each transistor having an emitter, the emitters being connected together, a base, the bases being connected to the respective first and second input terminals (T1, T2), and a collector and a pair of collector loads (R4, R5) operatively connected to the respective collectors of said first pair of transistors (Q5, Q6), said driving circuit providing said digital differential signal at the collectors of said first pair of transistors;

a drive controller including:

a second pair of transistors (Q7, Q8), each transistor having an emitter, the emitters being connected together, and each transistor having a collector, and one of the collectors of said second pair of transitors being operatively connected to the emitters of said first pair of transistors (Q5, Q6);

a constant current source (Q9, R6) operatively connected to the emitters of said second pair of transistors (Q7, Q8); and

a packet time detecting circuit (Q4, D1, C), operatively coupled to receive said input signal, supplying a first current to the drive controller by turning on one of the transistors of said second pair of transistors (Q7, Q8) when the level of the input signal received at said first and second input terminals (T1, T2) is variable and supplying a second current by turning on the other of the transistors of said second pair of transistors (Q7, Q8) when the input signal is not variable, characterized in that it further comprises a pair of current separating means (D2, D3; Q12, Q13), operatively connected to the other one of the collectors of said second pair of transistors (Q7, Q8) and being directly connected to said pair of collector loads (R4, R5), respectively, for causing one-half of the current provided by the constant current source (Q9, R6) to flow in each of the collector loads of said pair of collector loads to produce a mean voltage value level midway between said first and second levels at the collectors of said first pair of transistors (Q5, Q6) when the digital differential signal is not being transmitted, and the said drive controller supplying the current produced by said constant current source (Q9, R6) to said driving circuit during the packet time and to said current separating means during the idle time, respectively.

2. A driver as recited in claim 1, wherein said current separating means comprises first and second matched diodes (D2, D3) each having a cathode connected to the other one of the collectors of said second pair of transistors (Q7, Q8) and each having an anode, the anode of the first matched diode (D2) being connected to one of the collector loads of said pair of collector loads (R4, R5) and the anode of the second matched diode (D3) being connected to the other one of the collector loads of said pair of collector loads (R4, R5).

3. A driver as recited to claim 1, wherein said current separating means comprises first and second matched transistors (Q12, Q13) each having an emitter connected to the other one of the collectors of said second pair of transistors (Q7, Q8) and each having a collector, the collector of the first matched transistor (Q12) being connected to one of the collector loads of said pair of collector loads (R4, R5) and the collector of the second matched transistor (Q13) being connected to the other one of the collector loads of said pair of collector loads (R4, R5).

4. A driver as recited in claim 3, wherein said first and second matched transistors (Q12, Q13) each has a base supplied with a common voltage ($V_R$).

## Patentansprüche

1. Treiber, mit einer Eingangstransmissionsleitung (D, $\overline{D}$), und einer Ausgangstransmissionsleitung (X, $\overline{X}$), zum Übertragen eines digitalen Differenzsignals, als ein Paar von Signalen bei ersten und zweiten Pegeln längs einer Transmissionsleitung während einer Paketzeit, und um das digitale Differenzsignal während einer Leerlaufzeit nicht zu übertragen, welcher Treiber umfaßt:

erste und zweite Eingangsanschlüsse (T1, T2), die mit der Eingangstransmissionsleitung (D, $\overline{D}$) verbunden sind, um ein Eingangssignal zu empfangen;

erste und zweite Ausgangsanschlüsse (T3, T4), die mit der Ausgangstransmissionsleitung (X, $\overline{X}$) gekoppelt sind;

eine Treiberschaltung, die enthält:

ein erstes Paar von Transistoren (Q5, Q6), von denen jeder Transistor einen Emitter hat, welche Emitter miteinander verbunden sind, eine Basis, welche Basen mit den entsprechenden ersten und zweiten Eingangsanschlüssen (T1, T2) verbunden sind, und einen Kollektor, und ein Paar von Kollektorlasten (R4, R5), die wirkungsmäßig mit den entsprechenden Kollektoren des genannten ersten Paares von Transistoren (Q5, Q6) verbunden sind, welche Treiberschaltung das genannte Differenzsignal an den Kollektoren des genannten ersten Paares von Transistoren vorsieht;

einen Treibercontroller, der enthält:

ein zweites Paar von Transistoren (Q7, Q8), von denen jeder Transistor einen Emitter hat, welche Emitter miteinander verbunden sind, und jeder Transistor einen Kollektor hat, und einer der Kollektoren des genannten zweiten Paares von Transistoren wirkungsmäßig mit den Emittern des genannten ersten Paares von Transistoren (Q5, Q6) verbunden ist;

eine Konstantstromquelle (Q9, R6), die wirkungsmäßig mit den Emittern des genannten zweiten Paares von Transistoren (Q7, Q8) verbunden ist; und

eine Paketzeit-Detektorschaltung (Q4, D1, C), die wirkungsmäßig gekoppelt ist, um das genannte Eingangssignal zu empfangen, einen ersten Strom an den Treibercontroller durch Einschalten eines der Transistoren des genannten zweiten Paares von Transistoren (Q7, Q8) zu liefern, wenn der Pegel des an den genannten ersten und zweiten Eingangsanschlüssen (T1, T2) empfangenen Eingangssignals variabel ist, und einen zweiten Strom zu liefern, durch Einschalten des anderen der Transistoren des genannten zweiten Paares von Transistoren (Q7, Q8), wenn das Eingangssignal nicht variabel ist, dadurch gekennzeichnet, daß er ferner umfaßt, ein Paar von Stromtrenneinrichtungen (D2, D3; Q12, Q13), die wirkungsmäßig mit dem anderen der Kollektoren des genannten zweiten Paares von Transistoren (Q7, Q8) verbunden sind und direkt mit dem genannten Paar von Kollektorlasten (R4 bzw. R5) verbunden sind, um zu bewirken, daß eine Hälfte des Stromes, der durch die Konstantstromquelle (Q9, R6) geliefert wird, in jede der Kollektorlasten des genannten Paares von Kollektorlasten fließt, um einen mittleren Spannungswertpegel halbwegs zwischen den genannten ersten und zweiten Pegeln an den Kollektoren des genannten ersten Paares von Transistoren (Q5, Q6) zu erzeugen, wenn das digitale Differenzsignal nicht übertragen wird, und der genannte Treibercontroller den Strom, der durch die genannte Konstantstromquelle (Q9, R6) erzeugt wird, während der Paketzeit in die genannte Treiberschaltung bzw. während der Leerlaufzeit an die genannte Stromtrenneinrichtungen liefert.

2. Treiber nach Anspruch 1, bei dem die genannten Stromtrenneinrichtungen erste und zweite zusammengepaßte Dioden (D2, D3) umfaßt, die jeweils eine Kathode haben, die mit dem anderen der Kollektoren des genannten Paares von Transistoren (Q7, Q8) verbunden sind und jeweils eine Anode haben, wobei die Anode der ersten zusammengepaßten Diode (D2) mit einer der Kollektorlasten des genannten Paares von Kollektorlasten (R4, R5) verbunden ist, und die andere Anode der zweiten zusammengepaßten Diode (D3) mit der anderen der Kollektorlasten des genannten Paares von Kollektorlasten (R4, R5) verbunden ist.

3. Treiber nach Anspruch 1, bei dem die genannten Stromtrenneinrichtungen erste und zweite zusammengepaßte Transistoren (Q12, Q13) umfassen, von denen jeder einen Emitter hat, der mit dem anderen der Kollektoren des genannten zweiten Paares von Transistoren (Q7, Q8) verbunden ist, und jeder einen Kollektor hat, wobei der Kollektor des ersten zusammengepaßten Transistors (Q12) mit der einen der Kollektorlasten des genannten Paares von Kollektorlasten (R4, R5) verbunden ist, und der Kollektor des zweiten zusammengepaßten Transistors (Q13) mit der anderen der Kollektorlasten des genannten Paares von Kollektorlasten (R4, R5) verbunden ist.

4. Treiber nach Anspruch 3, bei dem die genannten ersten und zweiten zusammengepaßten Transistoren (Q12, Q13) jeweils eine Basis haben, denen eine gemeinsame Spannung ($V_R$) zugeführt wird.

**Revendications**

1. Dispositif d'excitation, doté d'une ligne de transmission d'entrée (D, $\overline{D}$) et d'une ligne de transmission de sortie (X, $\overline{X}$), permettant de transmettre un signal différentiel numérique, sous forme d'une paire de signaux d'un premier et d'un deuxième niveau, le long d'une ligne de transmission pendant un temps de paquet et de ne pas transmettre le signal différentiel numérique pendant un temps mort, ledit dispositif d'excitation comprenant:

des première et deuxième bornes d'entrée (T1, T2) couplées à la ligne de transmission d'entrée (D, $\overline{D}$) afin de recevoir un signal d'entrée;

des première et deuxième bornes de sortie (T3, T4) couplées à la ligne de transmission de sortie (X, $\overline{X}$);

un circuit d'excitation comportant:

une première paire de transistors (Q5, Q6) possédant chacun un émetteur, ces émetteurs étant connectés ensemble, une base, ces bases étant connectées aux première et deuxième bornes d'entrée (T1, T2), et un collecteur; et

une paire de charges de collecteur (R4, R5) fonctionnellement connectées aux collecteurs respectifs de ladite première paire de transistors (Q5, Q6), ledit circuit d'excitation produisant ledit signal différentiel numérique sur les collecteurs de ladite première paire de transistors;

un dispositif de commande d'excitation comportant:

une deuxième paire de transistors (Q7, Q8) possédant chacun un émetteur, ces émetteurs étant connectés ensemble, et un collecteur, l'un des collecteurs de ladite deuxième paire de transistors étant fonctionnellement connecté aux émetteurs de ladite première paire de transistors (Q5, Q6);

une source de courant constant (Q9, R6) fonctionnellement connectée aux émetteurs de ladite deuxième paire de transistors (Q7, Q8); et

un circuit de détection de temps de paquet (Q4, D1, C), fonctionnellement couplé de façon à recevoir ledit signal d'entrée, qui fournit un premier courant au dispositif de commande d'excitation en rendant conducteur l'un des transistors de ladite deuxième paire de transistors (Q7, Q8) lorsque le niveau du signal d'entrée reçu sur lesdites première et deuxième bornes d'entrée (T1, T2) est variable et qui fournit un deuxième courant en rendant conducteur l'autre des transistors de ladite deuxième paire de transistors (Q7, Q8) lorsque le signal d'entrée n'est pas variable, caractérisé en ce qu'il comprend en outre une paire de moyens de séparation de courant (D2, D3; Q12, Q13), qui sont fonctionnellement connectés à l'autre des collecteurs de ladite deuxième paire de transistors (Q7, Q8) et sont directement connectés à ladite paire de charges de collecteur (R4, R5) respectivement, afin de faire que le moitié du courant produit par la source de courant constant (Q9, R6) passe dans chacune des charges de collecteur de ladite paire de charges de collecteur afin de produire un niveau moyen de valeur de tension situé à mi-chemin entre lesdits premier et deuxième niveaux présents sur les collecteurs de ladite première paire de transistors (Q5, Q6) lorsque le signal différentiel numérique n'est pas en cours de transmission, et ledit dispositif de commande d'excitation fournissant respectivement le courant produit par ladite source de courant constant (Q9, R6) audit circuit d'excitation pendant le temps de paquet et auxdits moyens de séparation de courant pendant le temps mort.

2. Dispositif d'excitation selon la revendication 1, où lesdits moyens de séparation de courant comprennent des première et deuxième diodes appariées (D2, D3) possédant chacune une cathode connectée à l'autre des collecteurs de ladite deuxième paire de transistors (Q7, Q8) et une anode, l'anode de la première diode appariée (D2) étant connectée à l'une des charges de collecteur de ladite paire de charges de collecteur (R4, R5) et l'anode de la deuxième diode appariée (D3) étant connectée à l'autre des charges de collecteur de ladite paire de charges de collecteur (R4, R5).

3. Dispositif d'excitation selon la revendication 1, où lesdits moyens de séparation de courant comprennent des premier et deuxième transistors appariés (Q12, Q13) possédant chacun un émetteur connecté à l'autre des collecteurs de ladite deuxième paire de transistors (Q7, Q8) et un collecteur, le collecteur du premier transistor apparié (Q12) étant connecté à l'une des charges de collecteur de ladite paire de charges de collecteur (R4, R5) et le collecteur du deuxième transistor apparié (Q13) étant connecté à l'autre des charges de collecteur de ladite paire de charges de collecteur (R4, R5).

4. Dispositif d'excitation selon la revendication 3, où lesdits premier et deuxième transistors appariés (Q12, Q13) possèdent chacun une base recevant une tension commune ($V_R$).

FIG. 1   PRIOR ART

FIG. 2   PRIOR ART

FIG. 3     PRIOR ART

## FIG. 4

## FIG. 6

# FIG. 5